# EUROPÄISCHE PATENTSCHRIFT

(11) **EP 2 356 893 B1**
(45) Veröffentlichungstag und Bekanntmachung des Hinweises auf die Patenterteilung: **04.03.2015**
(21) Anmeldenummer: 09774837.0
(22) Anmeldetag: 07.12.2009
(51) Int. Cl.: F04D 25/06, H05K 7/20, H05K 7/14, F04D 25/14

(54) **LÜFTER**
VENTILATOR
VENTILATEUR

(30) Priorität: 08.12.2008 DE 202008016733 U
(43) Veröffentlichungstag der Anmeldung: 17.08.2011
(73) Patentinhaber: Ebm-Papst St. Georgen GmbH & CO. KG, 78112 St. Georgen (DE)
(72) Erfinder: WEISSER, Norbert, 78078 Niedereschach-Kappel (DE); PAFFENDORF, Marcel, 77793 Gutach (DE); LAUFER, Wolfgang, 78733 Aichhalden (DE); HERR, Jürgen, 78112 St. Georgen (DE); MAYER, Stefan, 78086 Brigachtal (DE)
(74) Vertreter: Raible, Tobias
(86) Internationale Anmeldenummer: PCT/EP2009/008710
(87) Internationale Veröffentlichungsnummer: WO 2010/075931

(56) Entgegenhaltungen:
- EP-A1- 1 898 685
- DE-A1-102007 037 230
- US-B1- 6 174 232

## Beschreibung

Die Erfindung betrifft einen Lüfter nach Art eines Axial- oder Diagonallüfters.

Zur Kühlung von elektronischen Geräten werden häufig mehrere Lüfter in einem Einschub parallel betrieben, z.B. in einem sogenannten Rack für Server, oder im Schaltschrank einer Mobilfunkstation. Die Verwendung mehrer Lüfter bewirkt eine Redundanz, d.h. wenn einer der Lüfter ausfällt, stellen der oder die restlichen Lüfter sicher, dass weiterhin genügend Kühlluft zur Verfügung steht.

Wenn in einem Einschub einer der Lüfter ausfällt und die anderen Lüfter weiter laufen, würde die Luft im Kurzschluss durch den stehenden Lüfter zirkulieren. Diese Kurzschlussströmung muss deshalb minimiert werden. Hierzu verwendet man Lüfter mit Rückschlagklappen, welche sich automatisch schließen, wenn Luft in die falsche Richtung strömt. Ein Beispiel hierfür zeigt die US 6 174 232 B1. Dort ist auch das Problem beschrieben, dass die verwendeten Rückschlagklappen einen zusätzlichen Strömungswiderstand darstellen und folglich die Lüfterleistung reduzieren.

Aus der EP 1 898 685 A1 kennt man einen Axiallüfter. Dieser hat ein Lüftergehäuse mit einer Lufteintrittsöffnung und einer Luftaustrittsöffnung. Der Lüfter hat eine Drehgelenkanordnung mit zwei Drehgelenken, die an einem Gelenkträger angeordnet sind. Mittels dieser Drehgelenke ist eine Rückschlagklappe drehbar gelagert, welche in ihrer Schließstellung die Luftaustrittsöffnung verschließt. Die Drehgelenke sind als elastische Gelenkbänder ausgebildet, welche die Rückschlagklappe in Schließrichtung beaufschlagen. Dadurch wird erreicht, dass in einem Lüftereinschub bei Ausfall eines Lüfters durch die geschlossene Rückschlagklappe die Kurzschlussströmung durch den ausgefallenen Lüfter minimiert wird.

Es ist folglich eine Aufgabe der Erfindung, einen neuen Lüfter bereit zu stellen.

Diese Aufgabe wird gelöst durch einen Lüfter gemäß Anspruch 1. Bei diesem kann durch die Verwendung einer Gelenkanbindung und einer hiervon getrennten Federanordnung der Rückschlagklappe ein Rückstellglied mit einer vergleichsweise geringen Rückstellkraft verwendet werden, welche im Betrieb des Lüfters einen geringen Öffnungswiderstand gegen eine entsprechende Luftströmungsrichtung erzeugt, die aber dennoch ausreicht, um das Gehäuse des Lüfters in jeder Einbaulage und/oder wenn eine Luftströmung in einer entgegengesetzten Strömungsrichtung auftritt, zu verschließen. Beim Betrieb des Lüfters wird zudem ein Klappern der Rückschlagklappe(n) vermieden.

Bevorzugte Weiterbildungen sind Gegenstand von Unteransprüchen. Eine besonders vorteilhafte Ausgestaltung ist Gegenstand des Anspruchs 11. Sie ermöglicht eine hohe Schließkraft im geschlossenen Zustand, kombiniert mit eine mäßig hohen Schließkraft im geöffneten Zustand.

Weitere Einzelheiten und vorteilhafte Weiterbildungen der Erfindung ergeben sich aus den im Folgenden beschriebenen und in den Zeichnungen dargestellten, in keiner Weise als Einschränkung der Erfindung zu verstehenden Ausführungsbeispielen. Es zeigt:
- Fig. 1: eine perspektivische Ansicht eines Lüfters 100 mit geschlossenen Rückschlagklappen 140, 150, 160, 170, gemäß einem ersten Ausführungsbeispiel,
- Fig. 2: eine perspektivische Ansicht des Lüfters 100 der Fig. 1 mit geöffneten Rückschlagklappen 140, 150, 160, 170,
- Fig. 3: eine Schnittansicht des Lüfters 100 der Fig. 1, gesehen längs der Linien III-III der Fig. 2, bei geöffneten Rückschlagklappen,
- Fig. 4: eine Schnittansicht des Lüfters 100, gesehen längs der Linie IV-IV der Fig. 1 und bei geschlossenen Rückschlagklappen,
- Fig. 5: eine raumbildliche Darstellung eines zweiten Ausführungsbeispiels, in einer Darstellung analog Fig. 1,
- Fig. 6: einen Schnitt, gesehen längs der Linie VI - VI der Fig. 5, welcher die Klappen in ihrer Schließstellung zeigt,
- Fig. 7: eine Darstellung analog Fig. 6, aber bei geöffneten Schließklappen,
- Fig. 8: eine raumbildliche Darstellung des Lüfters in seiner Stellung gemäß Fig. 7, und
- Fig. 9: eine Graphik, welche bei 196 die Schließkraft F beim ersten Ausführungsbeispiel (Fig. 1 bis 4) und bei 198 die Schließkraft F beim zweiten Ausführungsbeispiel (Fig. 5 bis 8) zeigt.

In der nachfolgenden Beschreibung beziehen sich die Begriffe links, rechts, vorne, hinten, oben und unten auf die jeweilige Zeichnungsfigur und können in Abhängigkeit von einer jeweils gewählten Ausrichtung (Hochformat oder Querformat) von einer Zeichnungsfigur zur nächsten variieren. Gleiche oder gleich wirkende Teile werden in den verschiedenen Figuren mit denselben Bezugszeichen bezeichnet und gewöhnlich nur einmal beschrieben.

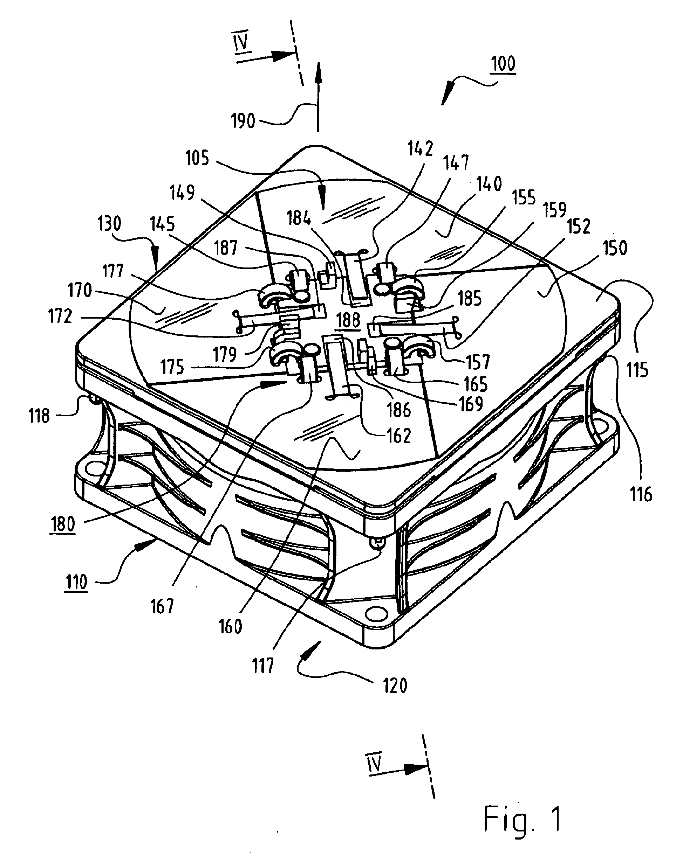

Fig. 1 zeigt ein erstes Ausführungsbeispiel eines Lüfters 100 mit einem Lüftergehäuse 110, welches eine Lufteintrittsöffnung 120 und eine Luftaustrittsöffnung 130 hat. Der Lüfter 100 ist bevorzugt ein Axial- oder Diagonallüfter, welcher im Betrieb eine Luftströmung in Richtung eines Pfeils 190 erzeugt.

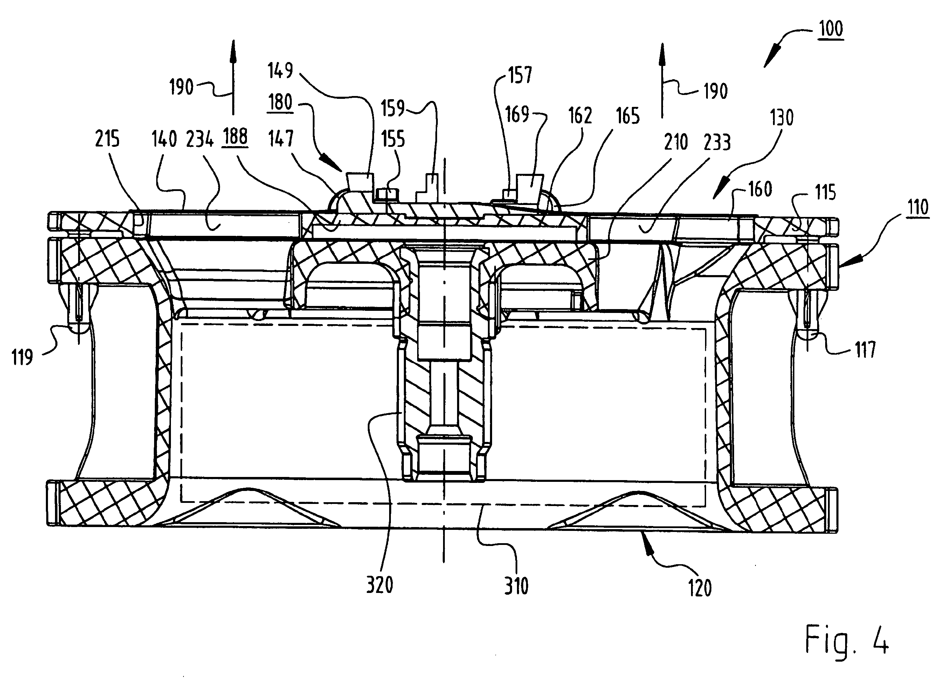

Das Lüftergehäuse 110 ist mit einer Rückschlagklappenanordnung 105 versehen, welche eine an einem Gelenkträger 188 angeordnete Drehgelenkanordnung 180 und eine vorgegebene Anzahl von Rückschlagklappen 140, 150, 160, 170 aufweist. Der Gelenkträger 188 ist beispielhaft an einem separaten Trägerelement 115 befestigt, welches über Befestigungselemente 116, 117, 118, 119 (Fig. 4) mit dem Lüftergehäuse 110 verbunden ist. Dieses Trägerelement 115 kann auch nach Art eines Nachleitrads ausgebildet sein.

Die Drehgelenkanordnung 180 hat eine vorgegebene Anzahl von Drehgelenken 145, 147, 155, 157, 165, 167, 175, 177, welche an dem Gelenkträger 188 angeordnet sind und mittels deren die Rückschlagklappen 140, 150, 160, 170 drehbar gelagert sind. Hierbei ist eine erste Rückschlagklappe 140 an Drehgelenken 145, 147 drehbar gelagert, eine zweite Klappe 150 an Drehgelenken 155, 157, eine dritte Klappe 160 an Drehgelenken 165, 167 und eine vierte Klappe 170 an Drehgelenken 175, 177. Die Drehgelenke 145, 147, 155, 157, 165, 167, 175, 177 sind bevorzugt als Scharniere ausgebildet.

Gemäß einer Ausführungsform ist jeder Rückschlagklappe 140, 150, 160, 170 mindestens ein elastisches Rückstellglied 142, 152, 162, 172 zugeordnet, welches diese Klappe 140, 150, 160, 170 in Richtung auf ihre Schließstellung beaufschlagt. Der Rückschlagklappe 140 ist das Rückstellglied 142, der Klappe 150 das Rückstellglied 152, der Klappe 160 das Rückstellglied 162 und der Klappe 170 das Rückstellglied 172 zugeordnet. Diese Rückstellglieder 142, 152, 162, 172 sind bevorzugt an der zugeordneten Rückschlagklappe 140, 150, 160 bzw. 170 befestigt und liegen unter Vorspannung gleitend gegen den Gelenkträger 188 an. Hierzu sind an dem Gelenkträger 188 Gleitflächen 184, 185, 186, 187 für die Rückstellglieder 142, 152, 162 bzw. 172 vorgesehen, vgl. Fig. 1.

Es wird jedoch darauf hingewiesen, dass die Befestigung der Rückstellglieder 142, 152, 162, 172 an den zugeordneten Rückschlagklappen 140, 150, 160 bzw. 170 lediglich beispielhaft und nicht als Einschränkung der Erfindung beschrieben ist. Andere Ausgestaltungen sind im Rahmen der Erfindung ebenfalls möglich. Z.B. können die Rückstellglieder 142, 152, 162, 172 an dem Gelenkträger 188 befestigt sein und gegen die zugeordneten Rückschlagklappen 140, 150, 160 bzw. 170 unter Vorspannung gleitend anliegen, um diese in Schließrichtung zu beaufschlagen.

Die Rückstellglieder 142, 152, 162, 172 sind bevorzugt als Federelemente, insbesondere als Federzungen, ausgebildet, welche an einem Ende an den Rückschlagklappen 140, 150, 160 bzw. 170 befestigt sind und am anderen Ende in den Gleitflächen 184, 185, 186 bzw. 187 gleitend gelagert sind. Hierbei sind die Rückschlagklappen 140, 150, 160, 170 und die zugeordneten Federzungen 142, 152, 162 bzw. 172 bevorzugt einstückig ausgebildet, beispielsweise aus einer Kunststofffolie. Diese kann eine Dicke aufweisen, welche gemäß einer Ausführungsform im Bereich von 0,02 mm bis 5 mm liegt. Alternativ hierzu können die Rückschlagklappen 140, 150, 160, 170 und die zugeordneten Federzungen 142, 152, 162 bzw. 172 als einstückiges Spritzgussteil oder als einstückiges ZweiKomponenten-Kunststoffteil ausgebildet sein.

Die Gleitflächen 184, 185, 186, 187 sind bevorzugt in Bereichen des Gelenkträgers 188 angeordnet, welche getrennt sind von Bereichen, die den als Scharnieren ausgebildeten Drehgelenken 145, 147, 155, 157, 165, 167, 175, 177 zugeordnet sind. Somit bilden die Scharniere 145, 147, 155, 157, 165, 167, 175, 177 und die von den Federzungen 142, 152, 162, 172 ausgebildeten Federanbindungen getrennte Achsen, sodass die Federlänge größer als die Scharnierlänge sein kann. Dies ermöglicht eine vorteilhafte Realisierung der Rückschlagklappenanordnung 105 mit Federzungen 142, 152, 162, 172, welche eine vergleichsweise niedrige Federkraft aufweisen. Die Federkraft kann, unabhängig von der Drehachse der Klappen, über den Abstand von der Drehachse, über Länge, Breite, Dicke und Form der Feder variiert werden. Durch richtige Auswahl der Federlänge und Federform kann ein Überdehnen der Feder verhindert oder stark reduziert werden.

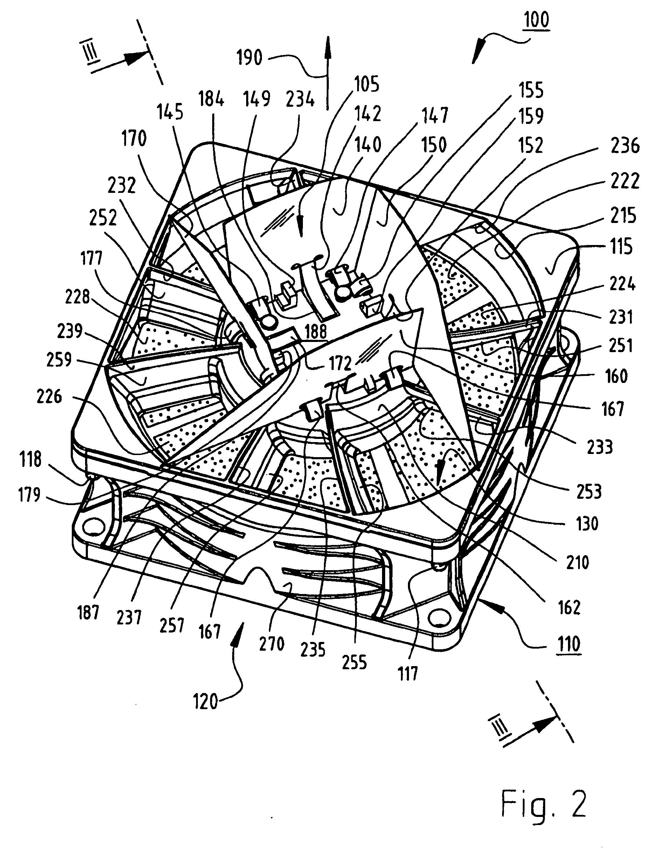

Gemäß einer Ausführungsform sind die Rückschlagklappen 140, 150, 160, 170 dazu ausgebildet, in ihrer Schließstellung, z.B. wenn der Lüfter 100 außer Betrieb bzw. ausgeschaltet ist, die Luftaustrittsöffnung 130 zumindest teilweise zu verschließen, und werden deshalb von den zugeordneten Federzungen 142, 152, 162 bzw. 172 in Schließrichtung beaufschlagt. Im Betrieb des Lüfters 100, der in Fig. 2 gezeigt ist, werden die Rückschlagklappen 140, 150, 160, 170 in Richtung des Pfeils 190 um die Drehgelenke 145, 147, 155, 157, 165, 167, 175, 177 gedreht und erstrecken sich dann im geöffneten Zustand vom Lüfter 100 weg. Um hierbei den Öffnungswinkel der Klappen 140, 150, 160 bzw. 170 in deren geöffnetem Zustand zu beschränken, ist diesen jeweils ein Anschlag 149, 159, 169 bzw. 179 zugeordnet. Beispielhaft ist der Rückschlagklappe 140 ein Anschlag 149, der Klappe 150 ein Anschlag 159, der Klappe 160 ein Anschlag 169 und der Klappe 170 ein Anschlag 179 zugeordnet. Der Anschlag kann auch durch Anlage an einer anderen Klappe reduziert werden.

Fig. 2 zeigt den Lüfter 100 von Fig. 1 im Betrieb. Hierbei werden die Rückschlagklappen 140, 150, 160, 170 von einer Luftströmung in Richtung des Pfeils 190, welche von Lüfterflügeln 222, 224, 226, 228 erzeugt wird, geöffnet, wie nachfolgend am Beispiel der Rückschlagklappe 140 beschrieben.

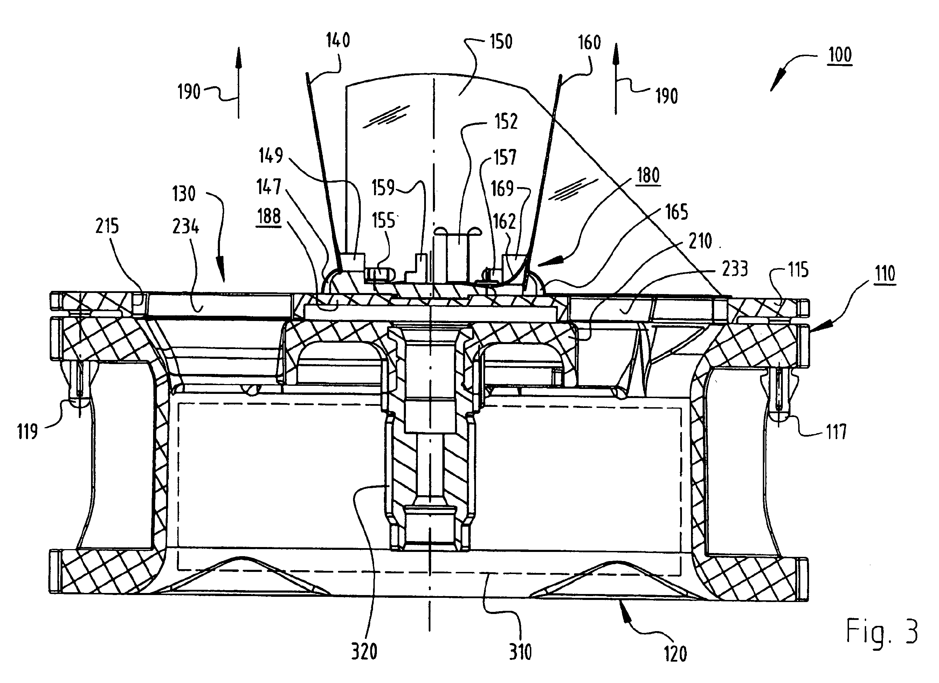

Gemäß einer Ausführungsform drückt die von den Lüfterflügeln 222, 224, 226, 228 erzeugte Luftströmung in Richtung des Pfeils 190 gegen die Rückschlagklappe 140, sodass diese um die Drehgelenke 145, 147 in Richtung des Pfeils 190 gegen die Federkraft der Federzunge 142 gedreht wird, wobei die Federzunge 142 auf der Gleitfläche 184 (Fig. 1) gleitet und der Luftströmung nur einen geringen Öffnungswiderstand entgegensetzt. Hierbei wird die Klappe 140 soweit geöffnet, bis diese gegen den Anschlag 149 anschlägt, vgl. Fig. 3, welcher somit den Öffnungswinkel der Klappe 140 im geöffneten Zustand einerseits beschränkt und andererseits gewährleistet, dass die Klappe 140 sich nur in die entgegen gesetzte Richtung wieder schließen kann. Außerdem ist die Klappe dauerhaft mit Luft beaufschlagt und kann deshalb nicht flattern. Dadurch wird der Verschleiß verringert.

Fig. 2 verdeutlicht eine Ausführungsform, in der der Gelenkträger 188 an dem Trägerelement 115 befestigt ist, welches über die Befestigungselemente 116 (Fig. 1), 117, 118, 119 (Fig. 4) mit dem Lüftergehäuse 110 verbunden ist. Das Trägerelement 115 ist rahmenförmig ausgebildet und hat eine Luftdurchtrittsöffnung 215, in welcher der Gelenkträger 188 über Stege 231, 232, 233, 234, 235, 236, 237, 239 gehalten wird. Die Stege bilden auch die Anschläge für die geschlossenen Klappen.

Gemäß einer Ausführungsform ist das Trägerelement 115 derart ausgebildet, dass der Gelenkträger 188 im Bereich eines Lüfterflanschs 210 angeordnet ist, welcher im Bereich der Luftaustrittsöffnung 130 vorgesehen ist und dort über zugeordnete Stege 251, 252, 253, 255, 257, 259 mit einer Außenwand 270 des Lüftergehäuses 110 verbunden ist, vgl. Fig. 3.

Es wird darauf hingewiesen, dass die Anordnung des Gelenkträgers 188 in dem Trägerelement 115 lediglich beispielhaft und nicht als Einschränkung der Erfindung beschrieben ist. Weitere Ausgestaltungen sind möglich, bei denen der Gelenkträger 188 z.B. unmittelbar am Lüfterflansch 210 befestigt ist. Dies kann beispielsweise durch Laserschweißen, Kleben, Ultraschall, Kaltgussformen, Verschrauben und/oder Verrasten mit dem Lüfterflansch 210 erfolgen. Alternativ hierzu kann der Gelenkträger 188 auch integrierter Bestandteil des Lüfterflanschs 210 sein. Bei diesen Ausführungsformen kann auf das Trägerelement 115 und die Stege 251, 252, 253, 255, 257, 259 verzichtet werden. Ebenso kann der Gelenkträger am Trägerelement 115 integriert sein.

Fig. 3 zeigt eine Schnittansicht des Lüfters 100 von Fig. 1, in welcher im Bereich eines Lagerrohrs 320 des Lüftergehäuses 110 angeordnete Komponenten 310 des Lüfters 100 angedeutet sind. Diese umfassen beispielhaft die Lüfterflügel 222, 224, 226, 228 von Fig. 2 sowie weitere elektronische und mechanische Bauteile des Lüfters 100, z.B. einen Elektromotor mit einer Statoranordnung und einer Rotorglocke, an der die Lüfterflügel 222, 224, 226, 228 befestigt sein können.

Fig. 3 verdeutlicht die Befestigung des Trägerelements 115 am Lüftergehäuse 110 mittels der Befestigungselemente 116 (Fig. 1), 117, 118 (Fig. 2), 119, sowie die Anordnung des Gelenkträgers 188 im Bereich des Lüfterflanschs 210. Die Befestigungselemente 116 (Fig. 1), 117, 118 (Fig. 2), 119 verrasten das Trägerelement 115 am Lüftergehäuse 110. Es ist jedoch ebenfalls möglich, das Trägerelement 115 am Lüftergehäuse 110 zu verschrauben, zu verkleben und/oder zu verschweißen.

Fig. 3 verdeutlicht auch die im Betrieb des Lüfters 100 gegen die Anschläge 149, 159, 169 anliegenden, und folglich mit einem maximalen Öffnungswinkel geöffneten Rückschlagklappen 140, 150 bzw. 160.

Fig. 4 zeigt eine Schnittansicht des Lüfters 100 von Fig. 1 mit geschlossenen Rückschlagklappen 140, 160, wobei die Wirkung der Federzunge 162 auf die Klappe 160 verdeutlicht wird, welche die Klappe 160 in Richtung auf ihre Schließstellung beaufschlagt.

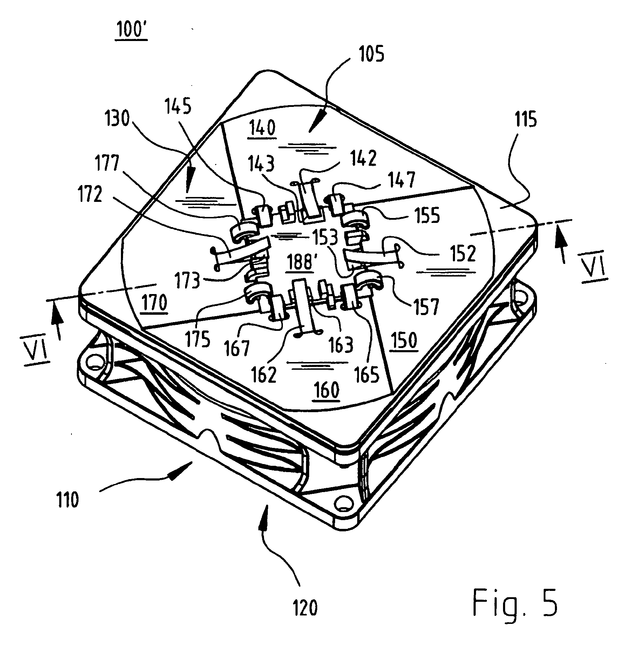

Die Fig. 5 bis 8 zeigen ein zweites Ausführungsbeispiel, bei welchem die Schließkraft F der Rückschlagklappen höher ist, wenn diese Klappen geschlossen sind oder sich in der Nähe ihrer Schließstellung befinden. Dadurch kann ein hässliches Klappern reduziert oder sogar ganz vermieden werden.

Da sich die Fig. 5 bis 8 von den Fig. 1 bis 4 nur wenig unterscheiden, werden weitgehend dieselben Bezugszeichen verwendet. Insoweit wird der Kürze halber auf die Beschreibung zu den Fig. 1 bis 4 verwiesen.

Ebenso wie die Fig. 1 bis 4 zeigen die Fig. 5 bis 8 einen Lüfter 100' mit einem Lüftergehäuse 110, welches eine Lufteintrittsöffnung 120 und eine Luftaustrittsöffnung 130 hat.

Am Lüftergehäuse 110 ist eine Anordnung 105 mit vier Rückschlagklappen 140, 150, 160, 170 befestigt. Diese hat einen Gelenkträger 188', und an diesem sind die Rückschlagklappen mittels Drehgelenken 145, 147, 155, 157, 165, 167, 175, 177 angelenkt.

Auch hier ist jeder Rückschlagklappe mindestens ein elastisches Rückstellglied 142, 152, 162, 172 zugeordnet.

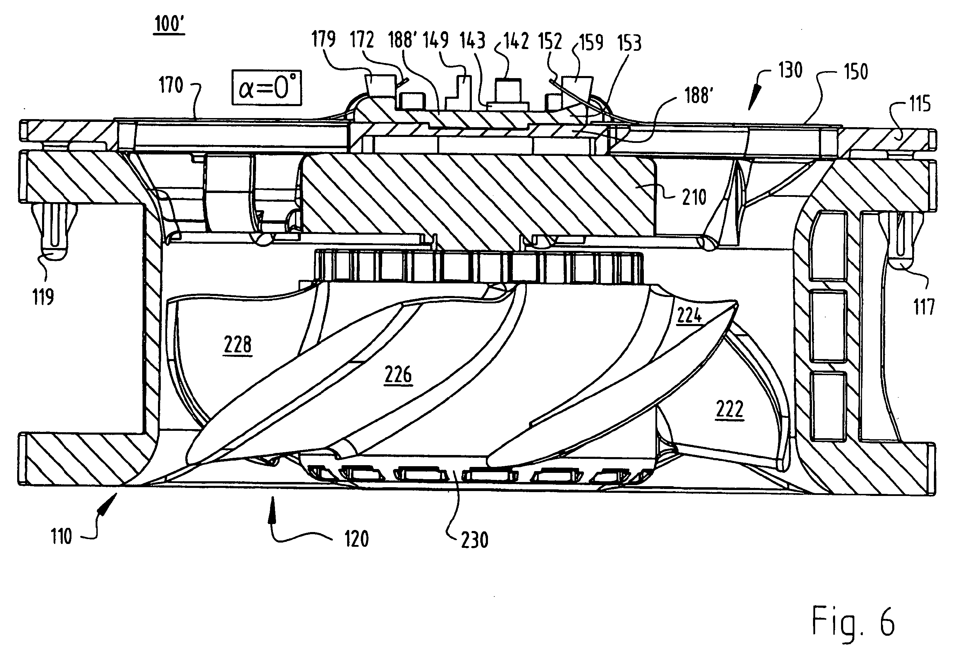

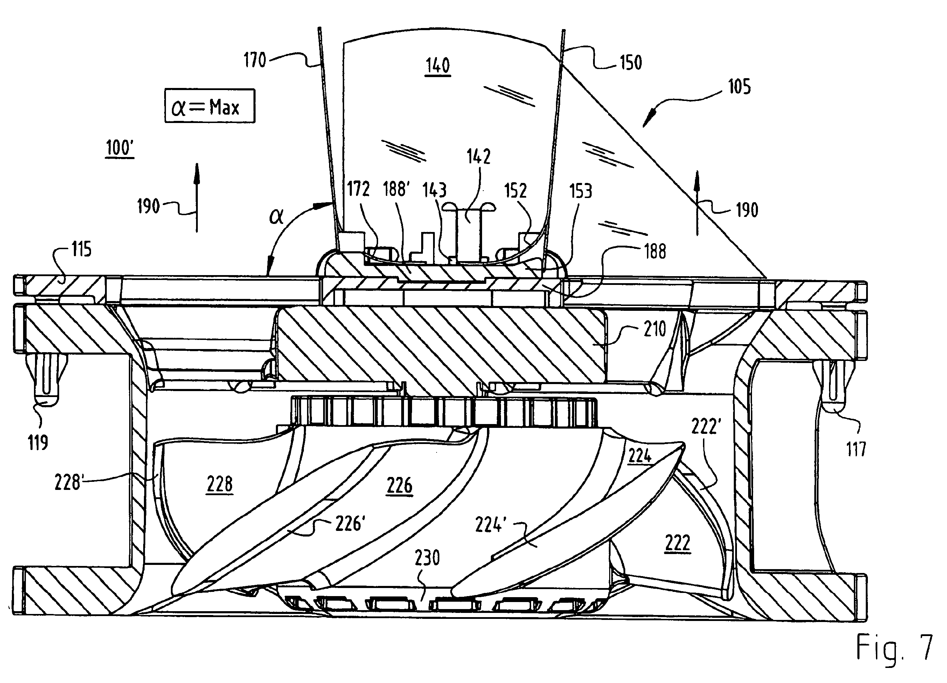

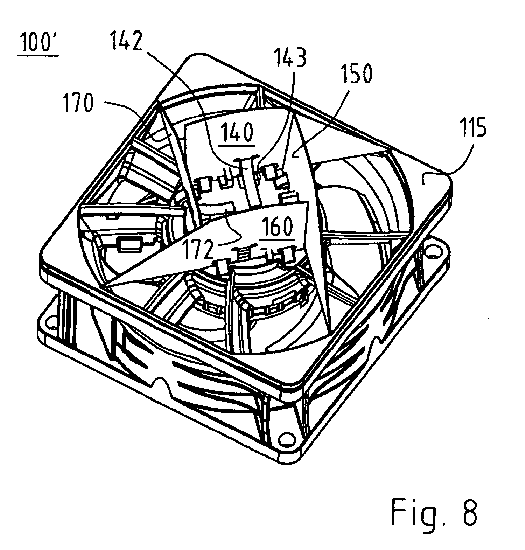

Im Unterschied zu den Fig. 1 bis 4 liegen bei Fig. 5 und 6 die Rückstellglieder bei geschlossenen Klappen gegen einen Nocken an. Fig. 6 zeigt einen solchen Nocken 143 für das Rückstellglied 142, und einen Nocken 153 für das Rückstellglied 152. Fig. 5 zeigt alle vier Nocken 143, 153, 163, 173, die bevorzugt identisch ausgebildet sind. Die Fig. 5 und 6 zeigen die Querschnittsform am Beispiel des Nockens 153. Dieser hat seine maximale Wirkung, wenn die betreffende Klappe 150 geschlossen ist. Bei geöffneter Klappe 150 (Fig. 7 und 8) hat der Nocken 153 nur noch die Wirkung eines Anschlags, welcher den Öffnungswinkel α der Klappe 150 auf einen maximalen Wert "Max." begrenzt.

Wie die Fig. 5 und 6 zeigen, sind hier die Nocken 143, 153, 163, 173 an einem separaten Formstück 188' vorgesehen, das am Gelenkträger 188 befestigt ist, z.B. durch Kleben oder Schweißen. Das erlaubt eine preiswerte Herstellung des Formstücks 188' und der Klappenanordnung 105.

Die Fig. 6 bis 8 zeigen Lüfterflügel 222, 224, 226, 228, die auf dem Außenrotor 230 eines elektronisch kommutierten Außenläufermotors angeordnet sind. Die Flügel haben an ihrer Peripherie Verbreiterungen 222', 224', 226', 228' (Fig. 7) mit einem Profil, das etwa dem einer Flugzeug-Tragfläche entspricht, wodurch eine Reduzierung der Lüftergeräusche erreicht wird.

Die Fig. 7 und 8 zeigen den Lüfter 100' im Betrieb, wobei die Klappen 140 bis 170 durch die Luftströmung 190 (Fig. 7) geöffnet sind. Die Rückstellglieder 142, 152, 162, 172 liegen nicht mehr gegen die Nocken 143 bis 173 an, vgl. Fig. 7, und diese Nocken dienen dann als Anschläge für die Klappen 140 etc., vgl. Fig. 7. Zusätzlich können noch weitere Anschläge vorgesehen werden.

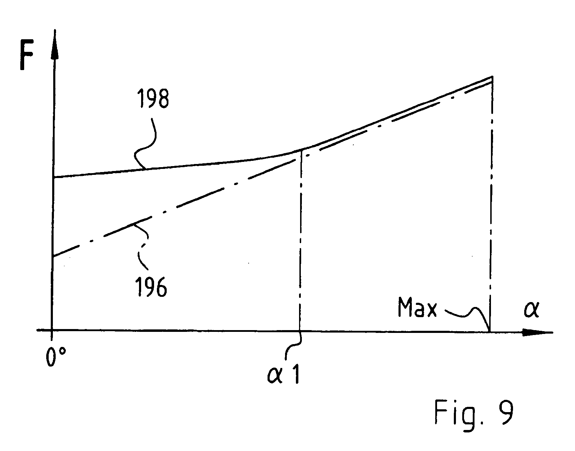

Fig. 9 zeigt eine Kurve 196, welche für die Fig. 1 bis 4 in Abhängigkeit vom Öffnungswinkel α der Klappe 140 etc. die Schließkraft F zeigt, also die Kraft, mit der eine Klappe 140 etc. gegen ihren Ventilsitz gepresst wird.

Ferner zeigt Fig. 9 eine Kurve 198, welche für die Fig. 5 bis 8 dieselbe Kraft F abhängig vom Winkel α zeigt. Man erkennt, dass in einem Winkelbereich von 0° bis α1, also etwa bis zur Hälfte des maximalen Öffnungswinkels, die Schließkraft F bei der Kurve 198 selektiv erhöht ist, was ein lästiges Klappern der Klappen 140 etc. bei den Fig. 5 bis 8 reduziert oder ganz vermeidet.

Naturgemäß sind im Rahmen der vorliegenden Erfindung vielfache Abwandlungen und Modifikationen möglich.

## Patentansprüche

1. Lüfter (100), insbesondere Axial- oder Diagonallüfter, mit einem Lüftergehäuse (110), welches aufweist:
Eine Lufteintrittsöffnung (120);
eine Luftaustrittsöffnung (130);
eine Drehgelenkanordnung (180) mit mindestens einem Drehgelenk (145, 147, 155, 157, 165, 167, 175, 177), welches an einem Gelenkträger (188; 188') angeordnet ist;
mindestens eine Rückschlagklappe (140, 150, 160, 170), welche drehbar durch das mindestens eine Drehgelenk (145, 147, 155, 157, 165, 167, 175, 177) gelagert ist und in ihrer Schließstellung die Luftaustrittsöffnung (130) zumindest teilweise verschließt;
mindestens ein elastisches Rückstellglied (142, 152, 162, 172), welches zwischen Rückschlagklappe (140, 150, 160, 170) und Gelenkträger (188; 188') angeordnet ist und entweder an der Rückschlagklappe befestigt ist und mit Vorspannung gegen den Gelenkträger (188; 188') gleitend anliegt,
oder am Gelenkträger befestigt ist und mit Vorspannung gegen die Rückschlagklappe gleitend anliegt,
und dadurch diese Rückschlagklappe (140, 150, 160, 170) in Schließrichtung beaufschlagt.

2. Lüfter nach Anspruch 1, bei welchem die Rückschlagklappe und das ihr zugeordnete Rückstellglied einstückig ausgebildet sind.

3. Lüfter nach Anspruch 1 oder 2, bei welchem die Rückschlagklappe (140, 150, 160, 170) und das elastische Rückstellglied (142, 152, 162, 172) aus einer Kunststofffolie ausgebildet sind, deren Dicke bevorzugt im Bereich von 0,01 bis 5 mm liegt.

4. Lüfter nach einem der vorhergehenden Ansprüche, bei welchem die Rückschlagklappe und das ihr zugeordnete elastische Rückstellglied als einstückiges Spritzgussteil ausgebildet sind.

5. Lüfter nach einem der vorhergehenden Ansprüche, bei welchem die Rückschlagklappe und das ihr zugeordnete elastische Rückstellglied als einstückiges Zwei-Komponenten-Kunststoffteil ausgebildet sind.

6. Lüfter nach einem der vorhergehenden Ansprüche, bei welchem das elastische Rückstellglied nach Art einer länglichen Federzunge ausgebildet ist.

7. Lüfter nach einem der vorhergehenden Ansprüche, bei welchem der Gelenkträger (188; 188') an einem Trägerelement (115) vorgesehen ist, welches mit dem Lüftergehäuse (110) verbindbar ist, und welches zusammen mit dem Gelenkträger (188) Luftdurchtrittsöffnungen definiert, welche durch die Rückschlagklappen (140, 150, 160, 170) verschließbar sind.

8. Lüfter nach Anspruch 7, bei welchem am Trägerelement (115) Befestigungselemente (116, 117, 118, 119) zur Befestigung am Lüftergehäuse (110) vorgesehen sind.

9. Lüfter nach einem der vorhergehenden Ansprüche, bei welchem der Gelenkträger (188;188') mindestens einen Anschlag (149, 159, 169, 179) aufweist, welcher bei geöffneter Rückschlagklappe deren Öffnungswinkel (α) beschränkt.

10. Lüfter nach einem der vorhergehenden Ansprüche, bei welchem dem elastischen Rückstellglied (142, ...), welches an der Rückschlagklappe (140, ...) befestigt ist, eine am Gelenkträger (188; 188') vorgesehene Gleitfläche (184, 185, 186, 187) zugeordnet ist, gegen welche das elastische Rückstellglied anliegt.

11. Lüfter nach Anspruch 10, bei welchem die Gleitfläche auf ihrer dem Drehgelenk für die ihr zugeordnete Rückschlagklappe zugewandten Seite mit einer nockenartigen Erhebung (143, 153, 163, 173) versehen ist, gegen welche das elastische Rückstellglied bei geschlossener Rückschlagklappe anliegt, und welche in dieser Stellung die Rückstellkraft (F) des Rückstellglieds (142, ...) erhöht.

12. Lüfter nach Anspruch 11, bei welchem die nockenartige Erhebung (143, 153, 163, 173) so ausgebildet ist, dass sie im Bereich der geöffneten Stellung der zugeordneten Rückschlagklappe (140, 150, 160, 170) die auf diese wirkende Rückstellkraft (F) nicht oder nicht wesentlich beeinflusst.

13. Lüfter nach Anspruch 11 oder 12, bei welchem die nockenartige Erhebung (143, 153, 163, 173) als Anschlag ausgebildet ist, gegen welchen die zugeordnete Rückschlagklappe in ihrer Offenstellung anliegt.

## Claims

1. Fan (100), in particular an axial or diagonal fan, having a fan housing (110) which has:
an air inlet aperture (120);
an air outlet aperture (130);
a swivel joint arrangement (180) having at least one swivel joint (145, 147, 155, 157, 165, 167, 175, 177) which is arranged on a joint-carrier (188; 188');
at least one non-return flap (140, 150, 160, 170) which is rotatably mounted by means of the at least one swivel joint (145, 147, 155, 157, 165, 167, 175, 177) and, in its closing position, at least partially occludes the air outlet aperture (130);
at least one elastic restoring member (142, 152, 162, 172) which is arranged between the non-return flap (140, 150, 160, 170) and the joint-carrier (188; 188') and which either is fastened to the non-return flap and rests, in a sliding manner, against the joint-carrier (188; 188') with pretensioning,
or is fastened to the joint-carrier and rests, in a sliding manner, against the non-return flap with pretensioning,
and thereby loads the said non-return flap (140, 150, 160, 170) in the direction of closing.

2. Fan according to Claim 1, in which the non-return flap and the restoring member associated with it are constructed in one piece.

3. Fan according to Claim 1 or 2, in which the non-return flap (140, 150, 160, 170) and the elastic restoring member (142, 152, 162, 172) are constructed from a plastic film, the thickness of which preferably lies within the range from 0.01 to 5 mm.

4. Fan according to one of the preceding claims, in which the non-return flap and the elastic restoring member associated with it are constructed as a one-piece injection-moulded part.

5. Fan according to one of the preceding claims, in which the non-return flap and the elastic restoring member associated with it are constructed as a one-piece dual-component plastic part.

6. Fan according to one of the preceding claims, in which the elastic restoring member is constructed after the manner of an elongated spring tongue.

7. Fan according to one of the preceding claims, in which the joint-carrier (188; 188') is provided on a carrier element (115) which can be connected to the fan housing (110) and which defines, together with said joint-carrier (188), air passage apertures which can be occluded by the non-return flaps (140, 150, 160, 170).

8. Fan according to Claim 7, in which fastening elements (116, 117, 118, 119) for fastening to the fan housing (110) are provided on the carrier element (115).

9. Fan according to one of the preceding claims, in which the joint-carrier (188; 188') has at least one stop (149, 159, 169, 179) which limits the angle of opening (α) of the non-return flap when said flap is open.

10. Fan according to one of the preceding claims, in which there is associated with the elastic restoring member (142, ...), which is fastened to the non-return flap (140, ...), a sliding surface (184, 185, 186, 187) which is provided on the joint-carrier (188; 188') and against which the elastic restoring member rests.

11. Fan according to Claim 10, in which the sliding surface is provided, on its side that faces towards the swivel joint for the non-return flap associated with said surface, with a cam-like elevation (143, 153, 163, 173) against which the elastic restoring member rests when the non-return flap is closed, and which, in this position, increases the restoring force (F) of the restoring member (142, ...).

12. Fan according to Claim 11, in which the cam-like elevation (143, 153, 163, 173) is constructed in such a way that, within the range of the open position of the associated non-return flap (140, 150, 160, 170), said elevation does not influence, or does not substantially influence, the restoring force (F) acting upon said flap.

13. Fan according to Claim 11 or 12, in which the cam-like elevation (143, 153, 163, 173) is constructed as a stop against which the associated non-return flap rests in its open position.

## Revendications

1. Ventilateur (100), en particulier ventilateur axial ou diagonal, avec un boîtier de ventilateur (110) qui présente :
une ouverture d'entrée d'air (120) ;
une ouverture de sortie d'air (130) ;
un ensemble d'articulation tournante (180), avec au moins une articulation tournante (145, 147, 155, 157, 165, 167, 175, 177) qui est disposée sur un support d'articulation (188 ; 188') ;
au moins un clapet anti-retour (140, 150, 160, 170), qui est monté à rotation au moyen de l'articulation tournante au moins unique (145, 147, 155, 157, 165, 167, 175, 177) et
qui dans sa position de fermeture ferme au moins partiellement l'ouverture de sortie d'air (130) ;
au moins un organe de rappel élastique (142, 152, 162, 172), qui est disposé entre le clapet anti-retour (140, 150, 160, 170) et le support d'articulation (188 ; 188') et qui soit est fixé sur le clapet anti-retour et s'applique à glissement avec précontrainte contre le support d'articulation (188 ; 188'),
soit est fixé sur le support d'articulation et s'applique à glissement avec précontrainte contre le clapet anti-retour,
et sollicite ainsi ce clapet anti-retour (140, 150, 160, 170) dans la direction de fermeture.

2. Ventilateur selon la revendication 1, dans lequel le clapet anti-retour et l'organe de rappel qui lui est associé sont réalisés d'un seul tenant.

3. Ventilateur selon la revendication 1 ou 2, dans lequel le clapet anti-retour (140, 150, 160, 170) et l'organe de rappel élastique (142, 152, 162, 172) sont formés à partir d'une feuille de matière plastique dont l'épaisseur se situe de préférence dans la plage de 0,01 à 5 mm.

4. Ventilateur selon l'une des revendications précédentes, dans lequel le clapet anti-retour et l'organe de rappel élastique qui lui est associé sont réalisés sous la forme d'une pièce d'un seul tenant moulée par injection.

5. Ventilateur selon l'une des revendications précédentes, dans lequel le clapet anti-retour et l'organe de rappel élastique qui lui est associé sont réalisés sous la forme d'une pièce d'un seul tenant en matière plastique à deux composants.

6. Ventilateur selon l'une des revendications précédentes, dans lequel l'organe de rappel élastique est réalisé à la manière d'une lame flexible oblongue.

7. Ventilateur selon l'une des revendications précédentes, dans lequel le support d'articulation (188 ; 188') est prévu sur un élément porteur (115), qui peut être relié au boîtier de ventilateur (110) et qui définit conjointement avec le support d'articulation (188) des ouvertures de passage d'air qui peuvent être fermées par les clapets anti-retour (140, 150, 160, 170).

8. Ventilateur selon la revendication 7, dans lequel des éléments de fixation (116, 117, 118, 119) sont prévus sur l'élément porteur (115) pour la fixation sur le boîtier de ventilateur (110).

9. Ventilateur selon l'une des revendications précédentes, dans lequel le support d'articulation (188 ; 188') présente au moins une butée (149, 159, 169, 179) qui limite l'angle d'ouverture (α) du clapet anti-retour lorsque ce dernier est ouvert.

10. Ventilateur selon l'une des revendications précédentes, dans lequel une surface de glissement (184, 185, 186, 187) prévue sur le support d'articulation (188 ; 188') est associée à l'organe de rappel élastique (142, ...) qui est fixé sur le clapet anti-retour (140, ...), surface contre laquelle s'applique l'organe de rappel élastique.

11. Ventilateur selon la revendication 10, dans lequel la surface de glissement est pourvue, sur son côté tourné vers l'articulation tournante pour le clapet anti-retour qui lui est associé, d'un bossage du genre saillie (143, 153, 163, 173) contre lequel s'applique l'organe de rappel élastique lorsque le clapet anti-retour est fermé, et qui augmente dans cette position la force de rappel (F) de l'organe de rappel (142, ...).

12. Ventilateur selon la revendication 11, dans lequel le bossage du genre saillie (143, 153, 163, 173) est configuré de telle sorte que, dans la zone de la position ouverte du clapet anti-retour associé (140, 150, 160, 170), il n'influence pas ou sensiblement pas la force de rappel (F) agissant sur ce dernier.

13. Ventilateur selon la revendication 11 ou 12, dans lequel le bossage du genre saillie (143, 153, 163, 173) est réalisé sous forme de butée, contre laquelle le clapet anti-retour associé s'applique dans sa position ouverte.
